# EUROPEAN PATENT APPLICATION

(11) **EP 2 461 648 A1**
(43) Date of publication of application: **06.06.2012**
(21) Application number: 10804460.3
(22) Date of filing: 28.07.2010
(51) Int. Cl.: H05B 33/22, H01L 51/50, H05B 33/12

(54) **LIGHT-EMITTING DEVICE**

(30) Priority: 29.07.2009 JP 2009176324
(71) Applicant: Sumitomo Chemical Company, Limited, Tokyo 104-8260 (JP)
(72) Inventor: ONO, Yoshinobu, Tsukuba-shi Ibaraki 300-3294 (JP)
(74) Representative: Jackson, Martin Peter
(86) International application number: PCT/JP2010/062724
(87) International publication number: WO 2011/013714

(57) **Abstract**

A light-emitting device includes a support substrate, a plurality of organic electroluminescence (EL) elements provided on the support substrate, and a partition wall separating the plurality of organic EL elements from each other. The partition wall has a peripheral portion arranged so as to surround a region in which the plurality of organic EL elements are provided, and a plurality of divider portions arranged in a striped pattern in a region surrounded by the peripheral portion and each having one end and the other end in a longitudinal direction coupled to the peripheral portion. The organic EL elements are arranged between the divider portions adjacent to each other. A depression extending toward the support substrate is provided in the peripheral portion on an extended line in the longitudinal direction of the divider portions.

## Description

### Technical Field

The present invention relates to a light-emitting device.

### Background Art

An organic electroluminescence element (hereinafter also referred to as an organic EL element) is configured to include a pair of electrodes of an anode and a cathode, and a light-emitting layer provided between the electrodes. When voltage is applied to this organic EL element, holes are injected from the anode and electrons are injected from the cathode. The injected holes and electrons are combined in the light-emitting layer, whereby light is emitted.

An organic EL element is advantageous in that a prescribed layer such as the light-emitting layer provided between the electrodes can readily be formed by a coating method. For example, the light-emitting layer can be formed by forming a film using ink including a material forming the light-emitting layer by a prescribed coating method, and then solidifying the film.

A nozzle printing method is contemplated as a coating method, because the tact time is short and clogging of a nozzle is less frequent. The nozzle printing method is a method of successively applying ink by successively discharging liquid column-like ink from a nozzle while moving the nozzle.

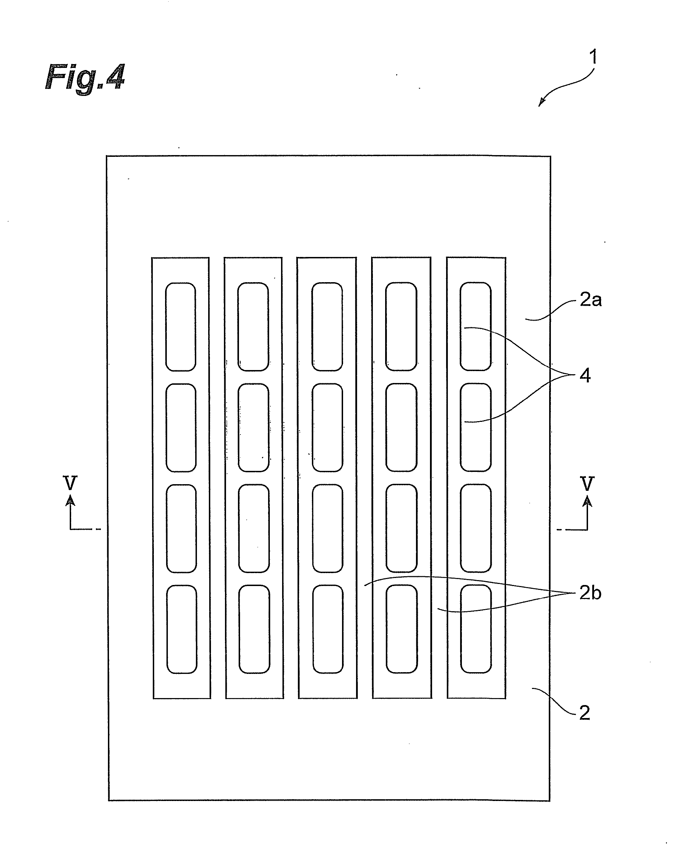

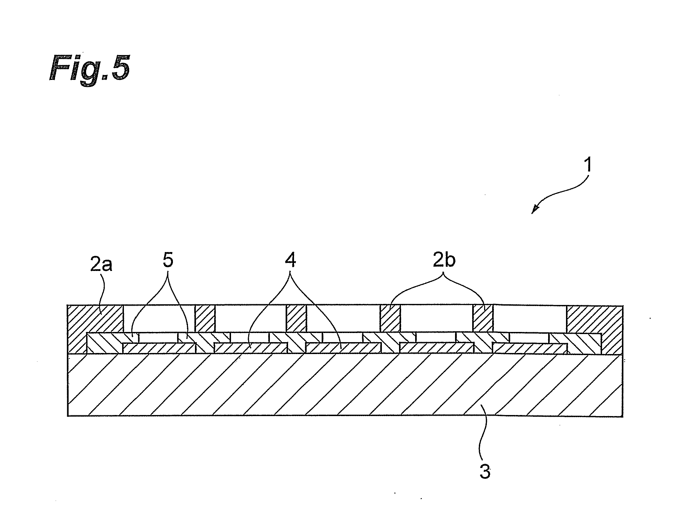

A method of forming a light-emitting layer by the nozzle printing method will be described with reference to FIG. 4 and FIG. 5. FIG. 4 is a plan view of a substrate 1 for pattern coating that is conventionally used to form organic EL elements. FIG. 5 is a sectional view of the substrate 1 for pattern coating as viewed from a cutting-plane line V-V in FIG. 4.

An organic EL element is used, for example, as a light source of a display device. In a display device, a plurality of organic EL elements are provided on a support substrate 3.

As shown in FIG. 4 and FIG. 5, mainly provided on the support substrate 3 are one of the electrodes 4 of pairs of electrodes of organic EL elements and an insulating film 5 electrically insulating each organic EL element. In addition, a partition wall 2 is provided on the support substrate 3 to accommodate coating liquid at a prescribed position when the organic EL elements are formed by a coating method. This partition wall 2 has a peripheral portion 2a surrounding a region in which a plurality of organic EL elements are provided, and a plurality of divider portions 2b arranged in a striped pattern in a region surrounded by the peripheral portion 2a and each having one end and the other end coupled to the peripheral portion 2a.

The organic EL elements are arranged like a matrix in the display device. Specifically, they each are arranged between the divider portions 2b adjacent to each other and discretely arranged between the divider portions 2b along the longitudinal direction of the divider portions 2b.

To form a light-emitting layer on such substrate 1 for pattern coating, first, while ink including a material forming a light-emitting layer is discharged like a liquid column from a nozzle of a nozzle printing apparatus, the nozzle scans along between the divider portions 2b to selectively supply ink between the divider portions 2b. Then, the supplied ink is solidified to form a light-emitting layer (for example, see Patent Literature 1).

### Citation List

### Patent Literature

Patent Literature 1: Japanese Patent Application Laid-Open No. 2002-75640

### Summary of Invention

### Technical Problem

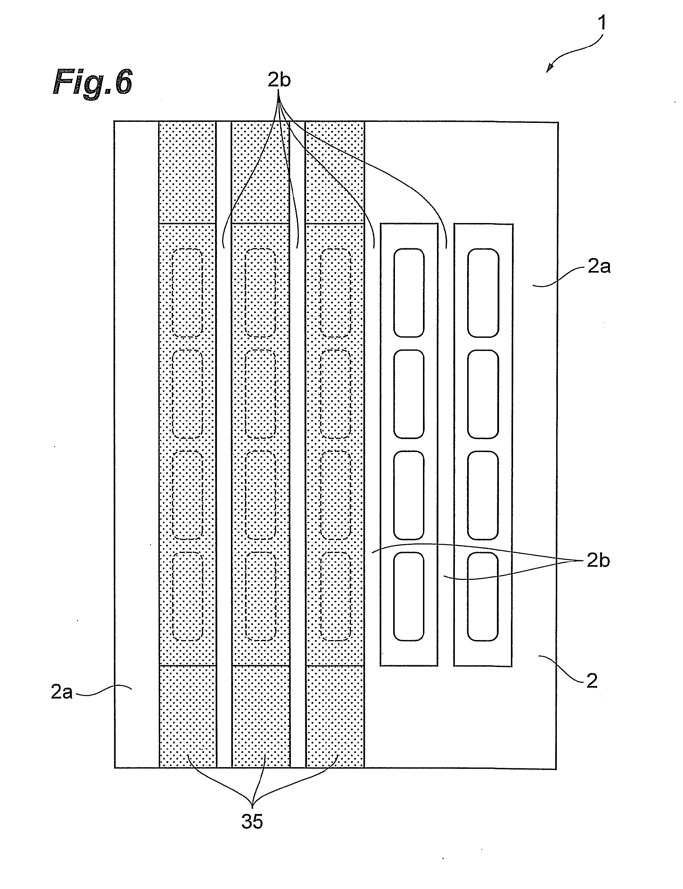

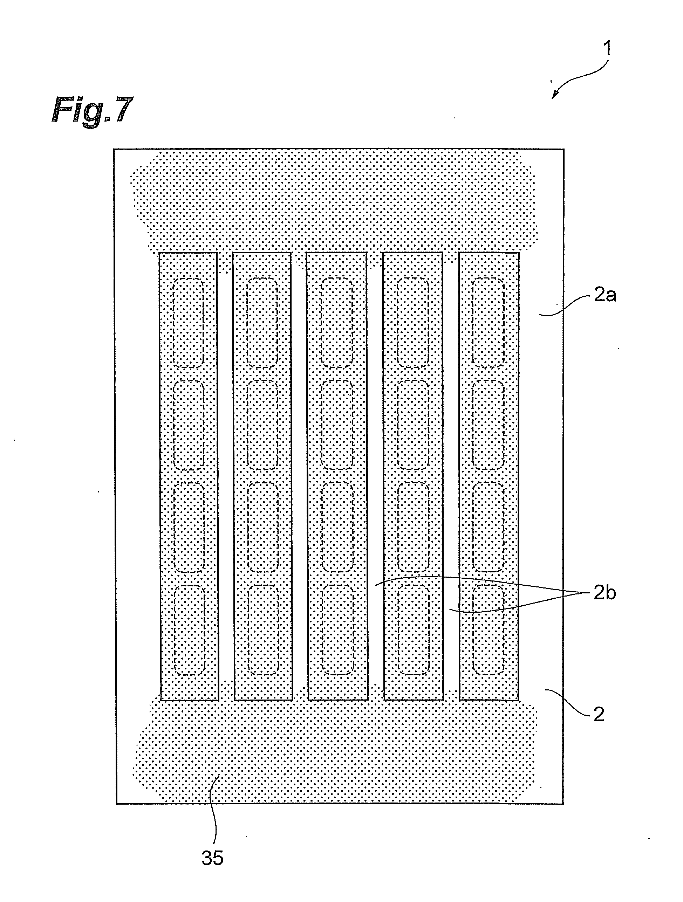

FIG. 6 and FIG. 7 are plan views of the conventional substrate 1 for pattern coating after ink is supplied by the nozzle printing method, wherein the ink (electroluminescence layer: EL layer 35) is hatched. In the nozzle printing method, ink is supplied with so-called one stroke without stopping discharge of the ink, so that the ink is supplied to a region other than the region to be supplied with ink. Specifically, in FIG. 6 and FIG. 7, ink is also applied onto the peripheral portion 2a of the partition wall 2. The ink applied onto the peripheral portion 2a of the partition wall 2 wets and spreads on the peripheral portion 2a, so that the ink (EL layer 35) applied to the adjacent columns sometimes comes into contact with each other (see FIG. 7) and then flows backward in between the divider portions 2b. Then, for example, in a case where the kinds of ink are different between the adjacent columns, a problem of color mixture arises. Furthermore, the backflow of ink may increase the film thickness of the light-emitting layer at opposite ends in the longitudinal direction between the divider portions 2b.

Therefore, an object of the present invention is to provide a light-emitting device having such a structure that can prevent ink applied to a region other than a region to be supplied with ink from flowing backward to the region to be supplied with ink and that can prevent mixture of ink, when ink is selectively supplied by a coating method.

### Solution to Problem

A light-emitting device of the present invention includes a support substrate, a plurality of organic electroluminescence elements provided on the support substrate, and a partition wall separating the plurality of organic electroluminescence elements from each other. The partition wall has a peripheral portion arranged so as to surround a region in which the plurality of organic electroluminescence elements are provided, and a plurality of divider portions arranged in a striped pattern in a region surrounded by the peripheral portion and each having one end and the other end in a longitudinal direction coupled to the peripheral portion. The organic electroluminescence elements are arranged between the divider portions adjacent to each other. A depression extending toward the support substrate is provided in the peripheral portion on an extended line in the longitudinal direction of the divider portions.

Preferably, a bottom surface of the depression is made of a material whose contact angle with respect to anisole is less than 30°.

Each of the organic electroluminescence elements may include a pair of electrodes. The light-emitting device may further include a dummy electrode on a bottom surface of the depression. The dummy electrode may be formed of the same material as one electrode of the pair of electrodes that is arranged closer to the support substrate. The depression may be provided so as to reach a surface of the dummy electrode.

The one electrode and the dummy electrode may be formed by a coating method.

The one electrode may be formed such that a wire-like conductor having conductivity is arranged in a film body exhibiting light transmittance.

The light-emitting device of the present invention may further include an insulating film electrically insulating the plurality of organic electroluminescence elements from each other and a dummy insulating film formed of the same member as the insulating film. The insulating film may be provided between the partition wall and the support substrate. The dummy insulating film may be provided on a bottom surface of the depression. The depression may be provided so as to reach a surface of the dummy insulating film.

### Advantageous Effects of Invention

The present invention can provide a light-emitting device having such a structure that can prevent ink applied to a region other than a region to be supplied with ink from flowing backward to the region to be supplied with ink and that can prevent mixture of ink, when ink is selectively supplied by a coating method.

### Brief Description of Drawings

FIG. 1 is a plan view of a light-emitting device 11 of the present invention.
FIG. 2 is an end view of the light-emitting device 11.
FIG. 3 is a plan view of a support substrate 21 in a state in which ink is applied.
FIG. 4 is a plan view of a conventional substrate 1 for pattern coating that is used to form organic EL elements.
FIG. 5 is a sectional view of the substrate 1 for pattern coating as viewed from a cutting-plane line V-V in FIG. 4.
FIG. 6 is a plan view of the conventional substrate 1 for pattern coating after ink is supplied by a nozzle printing method.
FIG. 7 is a plan view of the conventional substrate 1 for pattern coating after ink is supplied by the nozzle printing method.
FIG. 8 is a perspective view of the light-emitting device 11.
FIG. 9 is a perspective view of the light-emitting device 11 before formation of a light-emitting layer.
FIG. 10 is a diagram for explaining a contact angle 6 of anisole applied on a substrate.
FIG. 11 is a sectional view of an organic EL element 31.
FIG. 12 is a sectional view of the organic EL element 31.
FIG. 13 is a sectional view of the organic EL element 31.
FIG. 14 is a sectional view of the organic EL element 31.
FIG. 15 is a partial sectional view of the organic EL element 31.
FIG. 16 is a partial sectional view of the organic EL element 31.
FIG. 17 is a partial sectional view of the organic EL element 31.
FIG. 18 is a partial sectional view of the organic EL element 31.
FIG. 19 is a perspective view of a conductive resin electrode.
FIG. 20 is a perspective view of the light-emitting device 11 before formation of a light-emitting layer.
FIG. 21 is a perspective view of the light-emitting device 11 using a dummy insulating film.
FIG. 22 is a perspective view of the light-emitting device 11 before formation of a light-emitting layer using the dummy insulating film.
FIG. 23 is a perspective view of the light-emitting device 11 using a depression portion having an opening.
FIG. 24 is a perspective view of the light-emitting device 11 before formation of a light-emitting layer using the depression portion having an opening.

### Description of Embodiments

A light-emitting device of the present invention includes a support substrate 21, a plurality of organic EL elements 31 provided on the support substrate 21, and a partition wall 41 separating the plurality of organic EL elements 31 from each other.

The partition wall 41 has a peripheral portion 42 arranged so as to surround a region in which the plurality of organic EL elements are provided, and a plurality of divider portions 43 arranged in a striped pattern in a region surrounded by the peripheral portion 42 and each having one end and the other end coupled to the peripheral portion 42. The organic EL element is arranged between the divider portions 43 adjacent to each other. Then, on an extended line in a longitudinal direction Y from the divider portions (stripe portions) 43 in the peripheral portion 42, that is, at one ends and the other ends of the divider portions 43, depressions 44 are provided to extend toward the support substrate 21.

### <Configuration of Light-Emitting Device>

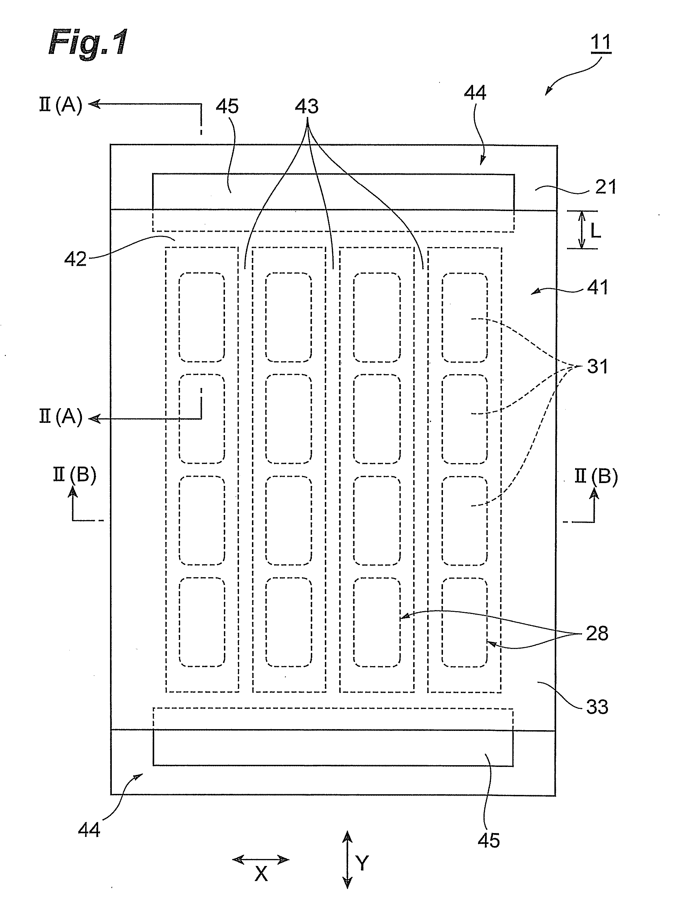

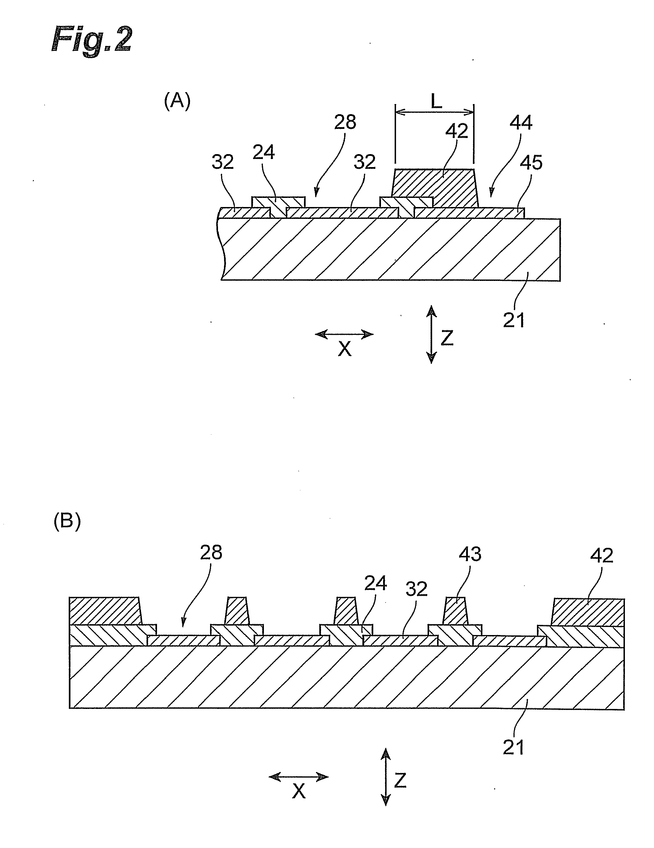

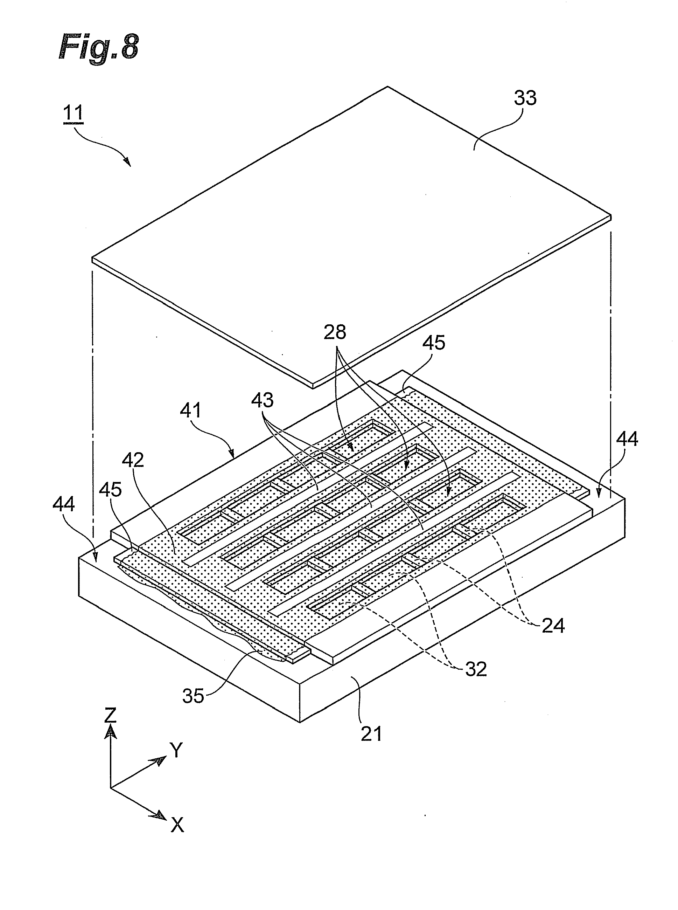

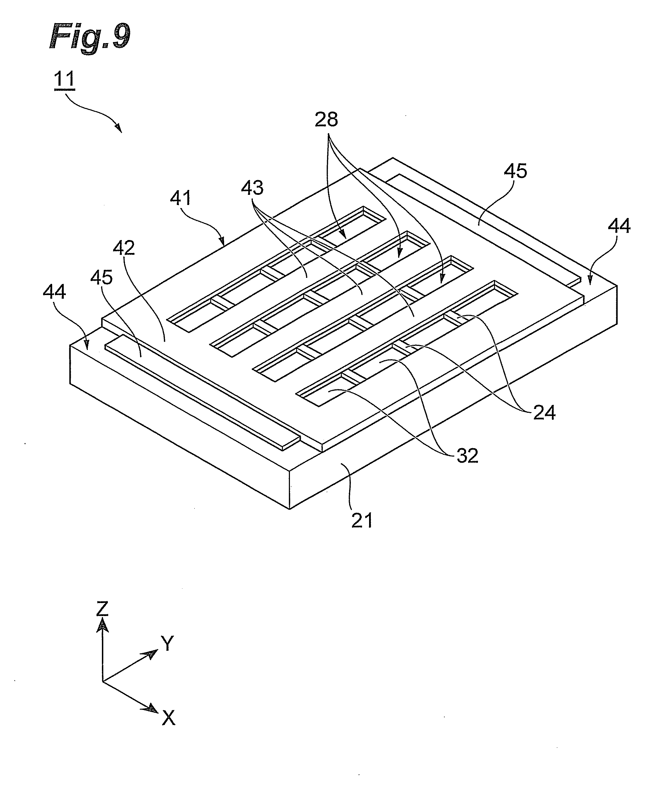

First, a configuration of the light-emitting device will be described with reference to FIG. 1 and FIG. 2. FIG. 1 is a plan view of this light-emitting device 11 of the present invention, and FIG. 2 is an end view of the light-emitting device 11. FIG. 2(A) shows the enlarged end surface of an end portion of the light-emitting device 11 when the light-emitting device 11 shown in FIG. 1 is cut along the plane vertical to a row direction X (the cross section taken along the arrow line II(A)-II(A) in FIG. 1), and FIG. 2(B) shows the end surface of the light-emitting device 11 shown in FIG. 1 cut along the plane vertical to a column direction Y (the cross section taken along the arrow line II(B)-II(B) in FIG. 1). It is noted that the illustration of the organic EL element is omitted excluding a lower electrode 32 in FIG. 2. FIG. 8 is a perspective view of the light-emitting device, showing the light-emitting device shown in FIG. 1 partially exploded, and FIG. 9 is a perspective view of the light-emitting device before formation of an electroluminescence layer (EL layer) 35 in the light-emitting device shown in FIG. 8.

In the following, an active matrix driving-type display device will be described as an example of the light-emitting device 11 having a plurality of organic EL elements. It is noted that the present invention is not limited to the active matrix driving type and is also applicable to, for example, a passive matrix driving-type display device and to prescribed light-emitting devices other than these display devices.

The plurality of organic EL elements 31 are arranged like a matrix on the support substrate 21. Specifically, the plurality of organic EL elements 31 are arranged at regular intervals in the row direction X and discretely arranged at regular intervals in the column direction Y on the support substrate 21. The row direction X and the column direction Y are directions vertical to each other and are directions vertical to a thickness direction Z of the support substrate 21. Although myriads of organic EL elements are generally provided in a display device, FIG. 1 shows a light-emitting device in which twenty organic EL elements are arranged in a matrix of four rows and four columns, for easiness of understanding. In FIG. 2, as for an organic EL element, only one electrode of a pair of electrodes is shown and the other configuration is not shown. In other words, in FIG. 2(A) and FIG. 2(B) showing the cross-sectional structure, the organic EL element 31 is not shown except for one electrode 32. In FIG. 1, the other electrode 33 is provided on the light-emitting layer of the organic EL element 31 to cover almost the entire surface of the substrate.

The partition wall 41 separating the organic EL elements 31 from each other is further provided on the support substrate 21. The partition wall 41 has the peripheral portion 42 arranged so as to surround a region in which the plurality of organic EL elements 31 are provided, and the plurality of divider portions 43 arranged in a striped pattern in a region surrounded by the peripheral portion 42. The divider portion 43 has one end and the other end in the longitudinal direction which are coupled to the peripheral portion 42. The peripheral portion 42 and the divider portions 43 are integrally formed.

In the present embodiment, the peripheral portion 42 of the partition wall 41 forms an approximately rectangular frame body. The peripheral portion 42 may not be an approximately rectangular frame body as long as it has a shape that surrounds the region in which the plurality of organic EL elements 31 are provided.

The plurality of divider portions 43 are arranged such that their longitudinal direction agrees with the column direction Y, and are arranged at regular intervals in the row direction X. In the present embodiment, the longitudinal direction of the divider portions 43 is also hereinafter referred to as the column direction Y since the longitudinal direction of the divider portions 43 agrees with the column direction Y The divider portion 43 is provided to separate each organic EL element 31 from another.

Each organic EL element 31 is provided between the divider portions 43 adjacent to each other. A depression portion formed by the divider portion 43 at one end in the row direction X and the peripheral portion 42 as well as a depression portion formed by the divider portion 43 at the other end in the row direction X and the peripheral portion 42 are also included in "between the divider portions 43" in the present description. In the present embodiment, the organic EL elements 31 are arranged at regular intervals along the column direction Y between the divider portions 43.

At one end and the other end in the column direction Y (the longitudinal direction of the divider portions) of the peripheral portion 42, the depressions 44 extending toward the support substrate are provided.

The organic EL element 31 has a pair of electrodes as described later. Preferably, the light-emitting device 11 has a dummy electrode 45 on a bottom surface of the depression 44. The dummy electrode 45 is formed of the same member as one electrode 32 of a pair of electrodes 32 that is arranged closer to the support substrate 21. Preferably, the depression 44 is provided to reach a surface of the dummy electrode 45. As long as steps extending toward the support substrate 21 are formed at one end and the other end in the column direction Y (the longitudinal direction of the divider portions) of the peripheral portion 42, the depression 44 may not be formed to reach the dummy electrode 45. In a manner in which the dummy electrode 45 is not provided, the depression 44 may be formed to reach the support substrate 21. Although the dummy electrode 45 is provided to be continuous in the row direction X in FIG. 1, it may be provided discretely in the row direction X in a similar way as one electrode 32. Not being limited to the same member as one electrode 32, the dummy electrode 45 may be formed of a member exhibiting an affinity for liquid or may be formed, for example, of the same member as the insulating film as described later.

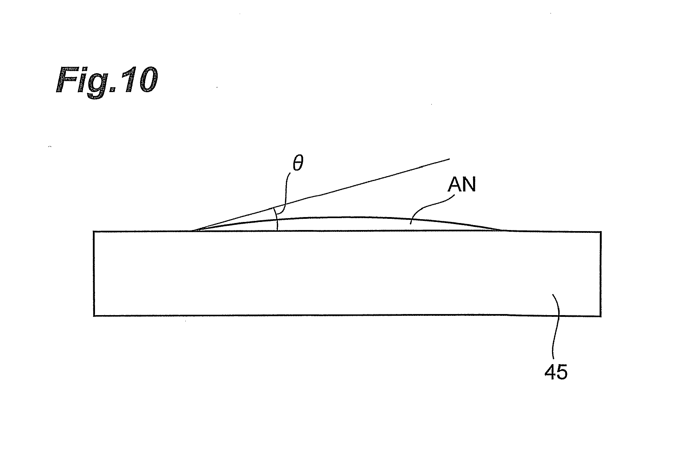

The bottom portion of the depression 44 is preferably such that ink wets and spreads at the bottom portion in order to prevent ink applied to the bottom portion from flowing backward between the divider portions 43. For this purpose, the bottom portion of the depression 44 preferably exhibits a greater affinity for liquid than the partition wall. FIG. 10 is a diagram showing a state of the contact between anisole AN included in ink and the bottom portion in the case where the dummy electrode 45 is used as the bottom portion of the depression 44. Specifically, the contact angle 6 of the bottom portion of the depression 44 with respect to anisole is preferably less than 30°. In a case where the dummy electrode 45 is provided and the depression 44 is provided to reach a surface of the dummy electrode 45, the bottom portion of the depression 44 corresponds to the surface of the dummy electrode 45. The main component of a solvent that dissolves an ink material forming the EL layer (organic layer) 35 is anisole, and the wettability of the contact surface of anisole can be quantified using the contact angle θ. That is, the smaller is the contact angle θ, the higher is the wettability. As shown in FIG. 10, the contact angle θ is the angle of the tangent along the outer surface of anisole at the contact position between the electrode surface and the outermost portion of anisole.

One electrode 32 of a pair of electrodes exhibiting conductivity generally exhibits a greater affinity for liquid than the partition wall. Therefore, when the dummy electrode 45 is formed with the same member as such a member, the dummy electrode 45 exhibiting an affinity for liquid can be fabricated in the same process step as one electrode 32. Therefore, the dummy electrode 45 exhibiting an affinity for liquid can be fabricated without increasing the number of steps when compared with the number of steps for forming a light-emitting device without a dummy electrode.

The organic EL element is configured to include a pair of electrodes and a light-emitting layer provided between the electrodes. One electrode 32 of a pair of electrodes that is arranged on the side of the support substrate 21 is provided for each organic EL element and is arranged at regular intervals in the row direction X on the support substrate 21 and discretely arranged at regular intervals in the column direction Y In the present embodiment, one electrode 32 is shaped like a plate and is approximately rectangular as two-dimensionally viewed.

An insulating film 24 providing electrical insulation is provided as necessary on the support substrate 21 having one of the electrodes 32 formed thereon. Openings 28 are provided in the insulating film 24, in each of which the surface of each electrode 32 is exposed. The insulating film 24 covers the edges of one of the electrodes 32, is formed continuously across one of the electrodes 32, and is provided in a grid pattern. In a region in which each opening 28 is formed, each of the organic EL elements emitting light independently from each other is arranged to serve as a pixel. The organic EL elements 31 are electrically insulated from each other by this insulating film 24. The divider portions 43 that constitute the aforementioned partition wall 41 are provided on this insulating film 24 in contact with the insulating film 24 formed in a grid pattern.

The organic EL element 31 has a prescribed organic layer or an inorganic layer provided as necessary in addition to the light-emitting layer between a pair of electrodes. The organic layer and the inorganic layer including the light-emitting layer are provided between the divider portions 43 and are each provided as one continuous layer over a plurality of organic EL elements arranged at regular intervals along the column direction Y At least one of the organic layer and the inorganic layer provided between a pair of electrodes is formed by the nozzle printing method described later.

The other electrode of a pair of electrodes is formed to be continuous over all the organic EL elements from one side in the thickness direction Z of the support substrate. In other words, the other electrode is provided as a common electrode.

### <Method of Manufacturing Light-Emitting Device>

A method of manufacturing the light-emitting device 11 will now be described.

First, the support substrate 21 is prepared. Next, of a pair of electrodes that constitute the organic EL element 31, one electrode 32 arranged on the side of the support substrate 21 is pattern-formed.

Preferably, one electrode 32 is formed by a coating method because of easiness of the process. For example, a conductive resin electrode described later is preferably formed, which is configured such that a wire-like conductor having conductivity is arranged in a film body exhibiting light transmittance. The details of the electrode formed by a coating method will be described later. The dummy electrode 45 formed of the same member as one electrode 32 is preferably formed simultaneously when one electrode 32 is formed. The dummy electrode 45 can be formed in the same process step as one electrode 32 since the dummy electrode 45 is formed of the same member as one electrode 32 in this manner. Therefore, the dummy electrode 45 can be formed without increasing the number of process steps.

Instead of a coating method, the electrodes 32 like a matrix may be formed by forming a conductive film of an electrode material described later on the entire surface of the support substrate 21, for example, by a sputtering method or a vapor deposition method, and then patterning the conductive film by photolithography. Alternatively, one of the electrodes may be pattern-formed on a prescribed base, which may be transferred onto the support substrate.

Next, the insulating film 24 is formed. The insulating film 24 is formed of an inorganic material or an organic material. Examples of the inorganic material forming the insulating film 24 include SiO₂ and SiN. The insulating film 24 is formed by depositing an inorganic insulating material on the entire surface of the substrate by a well-known method such as a plasma CVD method or a sputtering method and then patterning a thin film of the deposited inorganic material into a prescribed shape by photolithography. The openings 28 described above are drilled and provided when patterning is performed. The width of the opening 28 in the row direction X and the width thereof in the column direction Y are set as appropriate depending on the design including resolution. The width in the row direction X is generally 30 µm to 200 µm, and the width in the column direction Y is generally 100 µm to 500 µm.

The insulating film 24 made of an organic material may be formed using an acrylic resin-based, novalac resin-based, and/or polyimide resin-based positive-type or negative-type photosensitive material (photoresist). For example, the insulating film 24 patterned in a prescribed shape can be obtained by applying photoresist onto the substrate and applying light at a prescribed region through a prescribed mask for development. When patterning is performed, the openings 28 described above are drilled. Examples of the method of applying photoresist include methods using a spin coater, a bar coater, a roll coater, a die coater, a gravure coater, and a slit coater.

The insulating film 24 in a grid pattern as viewed from one side of the thickness direction of the support substrate 21 is formed through patterning in this way. The insulating film 24 is provided to achieve insulation between the organic EL elements 31. The thickness of the insulating film 24 is set to such a thickness that can ensure insulation between the organic EL elements 31. The thickness of the insulating film 24 is generally 0.1 µm to 1 µm, preferably 0.2 µm to 0.4 µm. The insulating film 24 may not be provided depending on the magnitude of electrical resistance of the organic material described later.

Next, the partition wall 41 is formed. The partition wall 41 having the peripheral portion 42 and the divider portions 43 is formed, for example, by applying the aforementioned photoresist on the entire surface and applying light at a prescribed region through a prescribed mask for development. In the present embodiment, in the development, the peripheral portion 42 and the divider portions 43 are formed by providing a plurality of openings elongated in the column direction Y in a layer of the photoresist and by removing one side and the other side in the column direction Y with prescribed widths being left from opposite ends of the plurality of openings. In this development, the surface of the dummy electrode 45 is exposed. In this manner, the peripheral portion 42 and the divider portions 43 are integrally formed in the same process step and therefore have the same height. The coating of photoresist may be performed by a method using a spin coater, a bar coater, a roll coater, a die coater, a gravure coater, a slit coater, or the like. The divider portions 43 of the partition wall 41 are provided to achieve insulation between the organic EL elements 31 adjacent to each other in the row direction X with the divider portion 43 interposed therebetween and to prevent color mixture between pixels adjacent to each other in the row direction X. In other words, the divider portions 43 are provided in order to prevent ink supplied to a depression portion defined between the divider portions 43 from overflowing beyond the divider portion 43 into the adjacent depression portion in the row direction X. The height of the partition wall 41 is set from this point of view and is generally 0.5 µm to 1.5 µm, preferably 0.5 µm to 1.0 µm. The width in the row direction X of the divider portion 43 is set as appropriate depending on the design including resolution, and is 2 µm to 50 µm, preferably 5 µm to 20 µm. The distance between the adjacent divider portions 43 is set as appropriate depending on the design including resolution and is generally 40 µm to 220 µm.

In order to accommodate the ink supplied between the divider portions 43 in between the partition wall, it is generally preferable that the partition wall 41 should exhibit liquid repellency. An organic material has its surface fluorinated and rendered liquid-repellent through plasma processing in an atmosphere containing fluorine. Therefore, after formation of the partition wall 41, the partition wall 41 can be rendered liquid-repellent through plasma processing in an atmosphere containing fluorine. For example, the surface of the partition wall 41 can be rendered liquid-repellent by performing CF₄ plasma processing. Liquid repellency may be imparted to the partition wall 41 by a method different from the method described above. For example, the partition wall 41 may be formed using a mixed material including a material exhibiting liquid repellency, or the step of covering the surface of the partition wall 41 with a substance exhibiting liquid repellency may be provided after formation of the partition wall 41. In the case where the insulating film 24 is formed of an organic material, the insulating film 24 is rendered liquid-repellent simultaneously by performing plasma processing in a fluorine-containing atmosphere.

Next, a prescribed organic layer or inorganic layer to be provided between a pair of electrodes is formed. Although an organic EL element has a variety of layered structures as described later, an organic EL element configured to include only a light-emitting layer between a pair of electrodes will be described below.

In the present embodiment, a method of forming a light-emitting layer by a coating method using a nozzle printing apparatus is described. A commercially-available nozzle printing apparatus can be used. For example, NP-300G manufactured by Dainippon Screen Co., Ltd. can be used.

First, ink including a material forming a light-emitting layer is supplied between the divider portions 43 using a nozzle printing apparatus. The ink includes a light-emitting material and a solvent as described later. With the liquid column-like ink being discharged from the nozzle of the nozzle printing apparatus, the nozzle arranged above between the divider portions 43 is moved to one side in the longitudinal direction, whereby the ink is supplied between the divider portions 43. In the nozzle printing method, ink is applied with so-called one stroke. More specifically, ink can be supplied successively between the divider portions 43 by repeating the following steps (1) to (4) in this order as a scan of the nozzle while discharging the liquid column-like ink from the nozzle. (1) First, the nozzle arranged above between the divider portions 43 is moved from one side to the other side of the column direction Y (downward in FIG. 1). (2) Then, the nozzle is moved to above between the adjacent divider portions 43 to one side of the row direction X (rightward in FIG. 1). (3) Then, the nozzle arranged above between the divider portions 43 is moved from the other side to one side in the column direction Y (upward in FIG. 1). (4) Then, the nozzle is moved to above between the adjacent divider portions 43 to one side in the row direction X (rightward in FIG. 1).

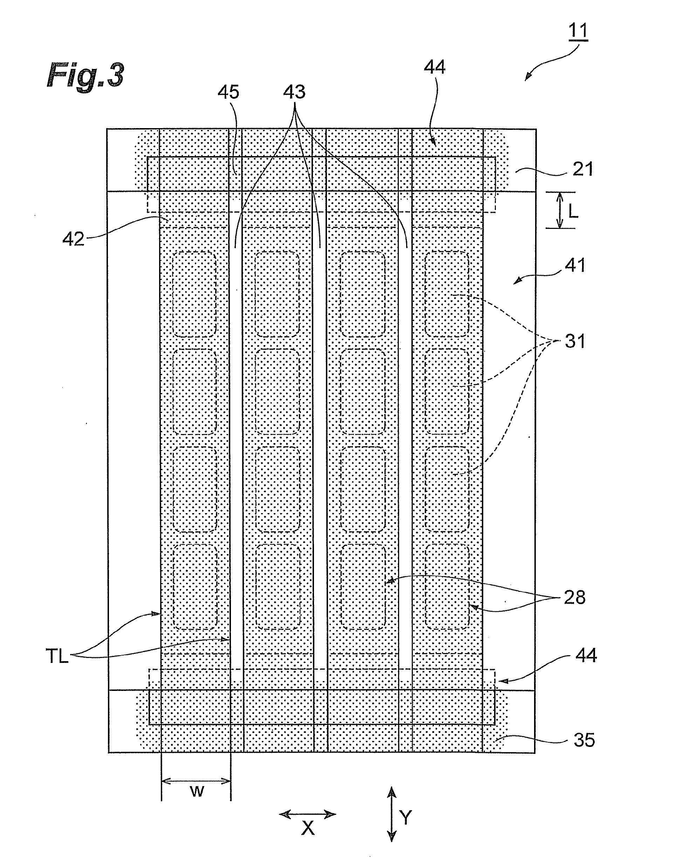

FIG. 3 is a plan view of the support substrate 21 coated with ink (EL layer 35), wherein the ink is hatched. In the nozzle printing method, ink is successively applied without stopping discharge of ink. Therefore, ink is applied beyond the peripheral portion 42 of the partition wall 41. In other words, ink is applied even to a region other than between the divider portions 43. Ink (EL layer 35) is supplied to a region between a pair of coating lines TL parallel to the Y direction. A width w between the coating lines TL is equal to the width in the X direction of a slit which is a partition wall opening region between the divider portions 43. In the present embodiment, since the depressions 44 are formed at one end and the other end of the peripheral portion 42 in the column direction Y (the longitudinal direction of the divider portions), the ink applied beyond the peripheral portion 42 of the partition wall 41 is supplied to the depressions 44. Then, this peripheral portion 42 functions as a divider separating the depressions 44 from between the divider portions 43. This can prevent the ink applied beyond the peripheral portion 42 of the partition wall 41 from flowing backward between the divider portions 43.

In particular, in the present embodiment, the dummy electrode 45 is formed of the same member as one electrode 32. The material forming one electrode 32 generally exhibits an affinity for liquid, and the contact angle thereof with respect to anisole is less than 30°. In the present embodiment, such dummy electrode 45 exhibiting an affinity for liquid is provided so as to be exposed. Therefore, the ink applied beyond the peripheral portion 42 of the partition wall 41 wets and spreads on the dummy electrode 45, and the ink once applied on the dummy electrode 45 retains on the dummy electrode 45, thereby preventing the ink applied beyond the peripheral portion 42 of the partition wall 41 from flowing backward between the divider portions 43.

Since the ink applied beyond the peripheral portion 42 of the partition wall 41 is prevented from flowing backward between the divider portions 43 in this manner, the thickness of the coating film supplied and formed between the divider portions 43 can be made uniform over the column direction Y

If a width L in the column direction Y of the peripheral portion to which one ends and the other ends in the longitudinal direction of the divider portions 43 are coupled is large, ink wets and spreads on the peripheral portion and as a result the ink applied on the peripheral portion flows backward between the divider portions 43. Therefore, in order to prevent ink from wetting and spreading on the peripheral portion, the width L in the column direction Y of the peripheral portion to which one ends and the other ends in the longitudinal direction of the divider portions 43 are coupled is preferably 200 µm or less, more preferably 100 µm or less.

The problem of color mixture does not arise in a display panel for a monochrome display device, whereas color mixture is a significant problem, for example, in a display panel for a color display device. For example, in the case of a display panel for a color display device, it is necessary to separately apply three kinds of ink including an R light-emitting material that emits light in red, a G light-emitting material that emits light in green, and a B light-emitting material that emits light in blue. Specifically, three kinds of ink are separately applied by applying each of ink including the R light-emitting material, ink including the G light-emitting material, and ink including the B light-emitting material between the divider portions 43 at intervals of two columns. In the case of using the nozzle printing method, each kind of ink is applied between the divider portions 43 with intervals of two columns with one stroke as described above. In a case where a conventional substrate without the depression 44 is used, three kinds of ink applied on the peripheral portion 42 mix together on the peripheral portion 42, and the mixed ink flows backward between the divider portions 43, which may cause color mixture (for example, see FIG. 6 and FIG. 7). In the present embodiment, however, even when the ink wets and spreads and thus mixes together in the depression 44, the peripheral portion 42 functions as a divider because of the provision of the depression 44, thereby to prevent the mixed ink from flowing backward between the divider portions 43. Therefore, the problem of color mixture can be prevented.

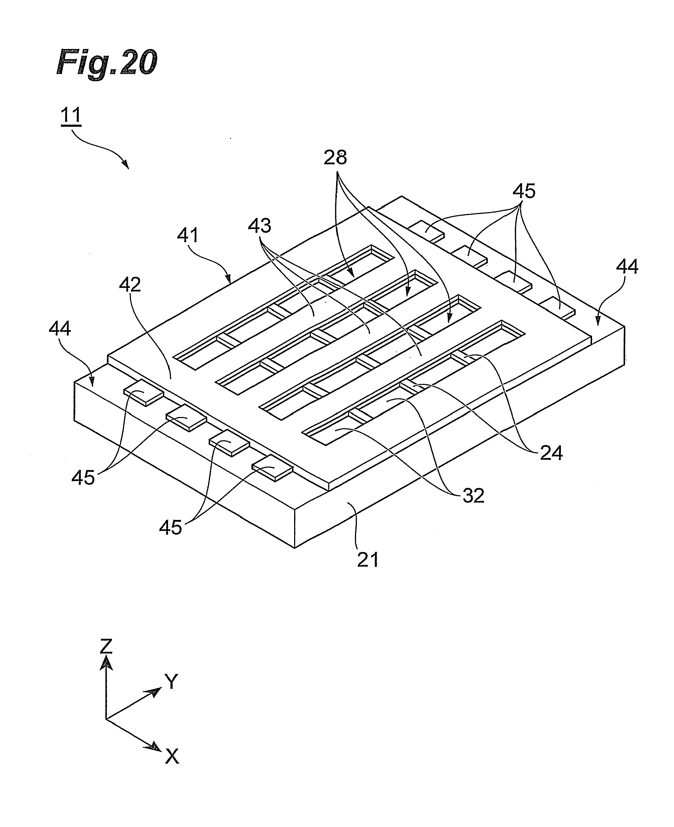

In FIG. 1, the dummy electrode 45 is provided to be continuous in the row direction X. However, as shown in FIG. 20, if a plurality of dummy electrodes 45 are discretely provided along the row direction X in a similar way as one of the electrodes 32, ink is held on the dummy electrodes 45 exhibiting an affinity for liquid. In FIG. 20, the state before formation of the light-emitting layer is shown to make it easy to understand the internal structure of the light-emitting device 11. The dummy electrodes 45 are provided on a surface of the support substrate 21 and, in this example, each provided for each opening region of the partition wall 41. The light-emitting device in FIG. 20 is the same as the light-emitting device described above except that the plurality of dummy electrodes 45 are spaced apart from each other.

The light-emitting layer can be formed by applying ink, followed by heating for a prescribed time at a prescribed temperature in an atmosphere such as an air atmosphere, an inert gas atmosphere, and a vacuum atmosphere.

After the light-emitting layer is formed, for example, the other electrode is formed. In the present embodiment, the other electrode is formed, for example, so as to be continuous over all the organic EL elements from one side of the thickness direction Z of the support substrate, using an electrode material as described later by a vapor deposition method and/or a sputtering method.

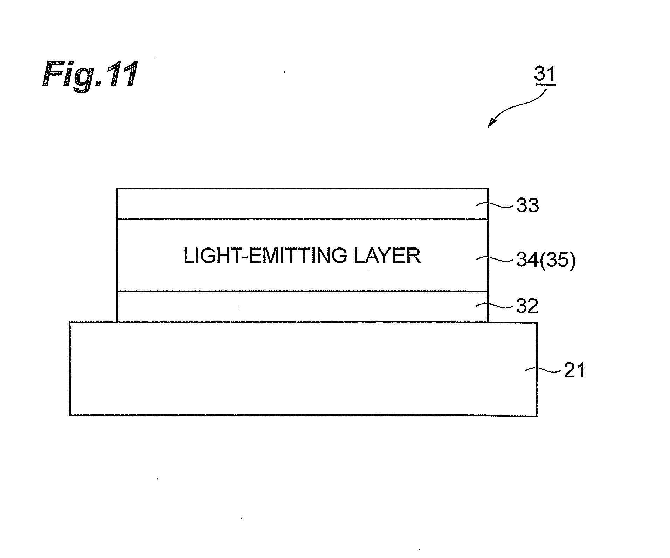

FIG. 11 is a longitudinal sectional view of a single organic EL element 31.

The organic EL element 31 includes the lower electrode 32 formed on the support substrate 21, a light-emitting layer 34 (EL layer 35) formed on the lower electrode 32, and an upper electrode 33 formed on the EL layer 35. When bias voltage is applied between the lower electrode 32 and the upper electrode 33, electrons and holes are injected from the respective electrodes into the EL layer 35. The injected electrons and holes are combined in the light-emitting layer 34, so that the light-emitting layer 34 emits light, which is output in the thickness direction of the substrate 21. If at least one of the electrodes 32 and 33 is fabricated as a transparent electrode, the emitted light is transmitted through the transparent electrode and output to the outside. In a case where the lower electrode 32 and the support substrate 21 are transparent, light from the light-emitting layer 34 is transmitted through them and output to the outside.

The manner in which only the light-emitting layer 34 is provided between the pair of electrodes 32 and 33 has been described above. However, prescribed layers different from the light-emitting layer 34 can be provided between a pair of electrodes. If the prescribed layers can be formed using a coating method, the prescribed layers are preferably formed by the nozzle printing method described above using ink including materials forming the prescribed layers in a similar way as the light-emitting layer 34. The prescribed layers and the light-emitting layer 34 as a whole contribute to light emission and thus constitute the EL layer 35. It is assumed that the lower electrode 32 is an anode and the upper electrode 33 is a cathode, by way of example.

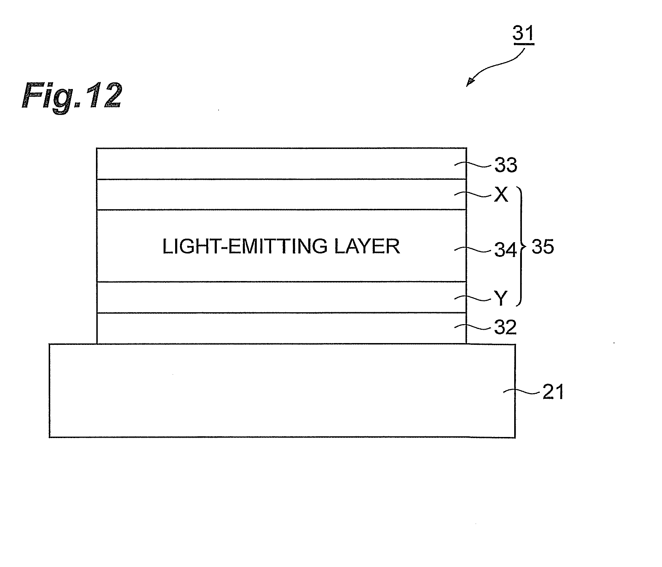

FIG. 12 is a longitudinal sectional view of the organic EL element 31, wherein a layer X is interposed between the upper electrode 33 and the light-emitting layer 34, and a layer Y is interposed between the lower electrode 32 and the light-emitting layer 34. The layer X and the layer Y each are composed of one kind or plural kinds of layers.

Assuming that the upper electrode 33 is a cathode, examples of the layer X provided between the cathode (electrode 33) and the light-emitting layer 34 include an electron injection layer, an electron transport layer, and a hole block layer. In a case where the layer X is composed of a single layer, it is assumed as an electron transport layer.

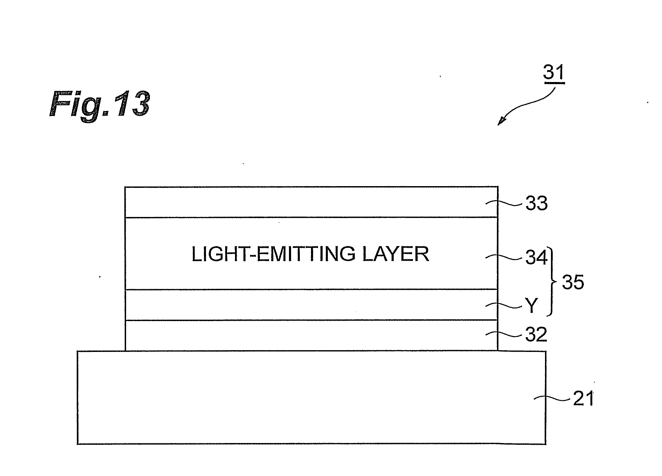

FIG. 13 is a longitudinal sectional view of the organic EL element 31, wherein the upper electrode 33 and the light-emitting layer 34 are in direct contact with each other, and the layer Y is interposed between the lower electrode 32 and the light-emitting layer 34. The layer Y is composed of one kind or plural kinds of layers and is in contact with both of the lower electrode 32 and the light-emitting layer 34.

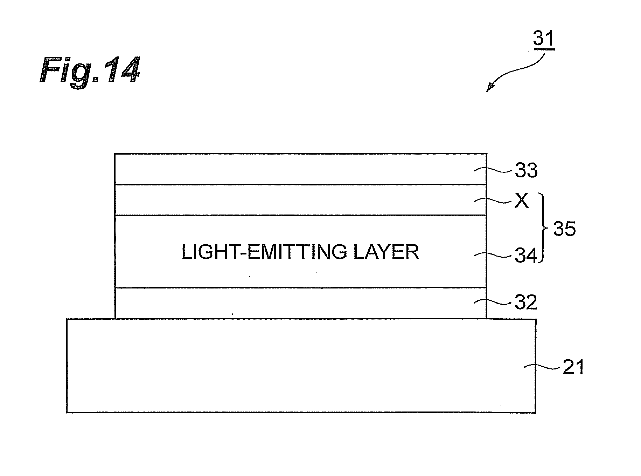

FIG. 14 is a longitudinal sectional view of the organic EL element 31, wherein the lower electrode 32 and the light-emitting layer 34 are in direct contact with each other, and the layer X is interposed between the upper electrode 33 and the light-emitting layer 34. The layer X is composed of one kind or plural kinds of layers and is in contact with both of the upper electrode 33 and the light-emitting layer 34.

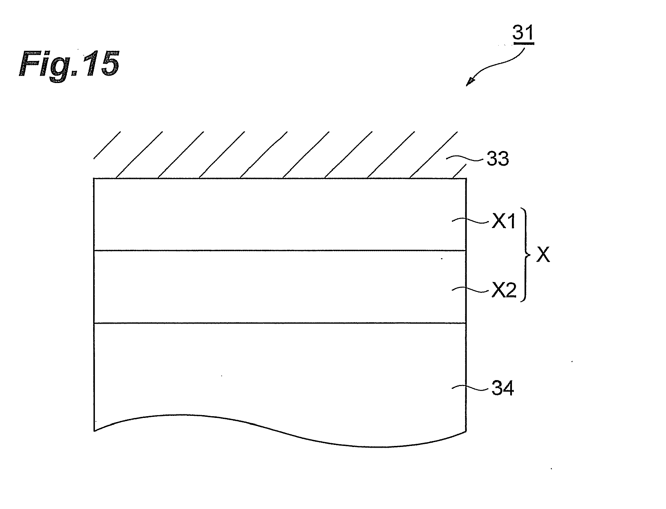

FIG. 15 is a longitudinal sectional view of the organic EL element 31, showing an example in which two layers X1 and X2 are interposed between the upper electrode 33 and the light-emitting layer 34. More specifically, in the case where the electron injection layer X1 and the electron transport layer X2 are both provided between the cathode (electrode 33) and the light-emitting layer 34, the layer in contact with the cathode (electrode 33) is referred to as the electron injection layer X1, and the layer excluding this electron injection layer X1 is referred to as the electron transport layer X2.

The electron injection layer X1 is a layer having a function of improving the efficiency of electron injection from the cathode. The electron transport layer X2 is a layer having a function of improving electron injection from the cathode, the electron injection layer, or the electron transport layer closer to the cathode. The hole block layer is a layer having a function of blocking transport of holes. When the electron injection layer and/or the electron transport layer have the function of blocking transport of holes, these layers may also serve as the hole block layer.

Whether the hole block layer has the function of blocking transport of holes can be determined, for example, by fabricating an element that only allows hole current to flow and by confirming the effect of blocking based on a reduction of the current value.

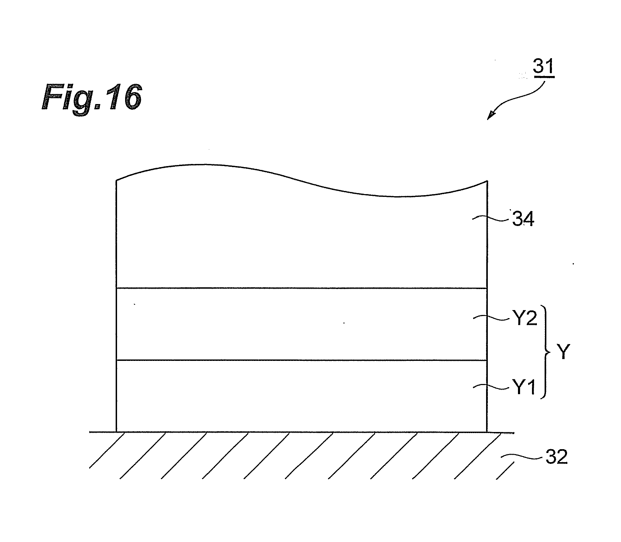

FIG. 16 is a longitudinal sectional view of the organic EL element 31, showing an example in which two layers Y1 and Y2 are interposed between the lower electrode 32 and the light-emitting layer 34. More specifically, examples of the layer Y provided between the anode (electrode 32) and the light-emitting layer 34 include a hole injection layer, a hole transport layer, and an electron block layer. In a case where only one layer is provided between the anode (electrode 32) and the light-emitting layer 34, this layer is referred to as a hole injection layer. In the case where the hole injection layer Y1 and the hole transport layer Y2 are both provided between the anode (electrode 32) and the light-emitting layer 34, the layer in contact with the anode (electrode 32) is referred to as the hole injection layer Y1, and the layer excluding this hole injection layer Y1 is referred to as the hole transport layer Y2.

The hole injection layer Y1 is a layer having a function of improving the efficiency of hole injection from the anode (electrode 32). The hole transport layer Y2 is a layer having a function of improving hole injection from the anode (electrode 32), the hole injection layer Y1, or the hole transport layer closer to the anode. The electron block layer is a layer having a function of blocking transport of electrons. When the hole injection layer and/or the hole transport layer have the function of blocking transport of electrons, these layers may also serve as the electron block layer.

Whether the electron block layer has the function of blocking transport of electrons can be determined by fabricating an element that only allows electron current to flow and by confirming the effect of blocking based on a reduction of the current value.

It is noted that the electron injection layer and the hole injection layer may also collectively be referred to as a charge injection layer, and the electron transport layer and the hole transport layer may also collectively be referred to as a charge transport layer.

Examples of the layered structure employed by the organic EL element are shown below:
a) anode/light-emitting layer/cathode (the configuration shown in FIG. 11);
b) anode/hole injection layer/light-emitting layer/cathode (the configuration in FIG. 13 in which the layer Y is a hole injection layer);
c) anode/hole injection layer/light-emitting layer/electron injection layer/cathode (the configuration in FIG. 12 in which the layer Y is a hole injection layer and the layer X is an electron injection layer);
e) anode/hole injection layer/light-emitting layer/electron transport layer/cathode (the configuration in FIG. 12 in which the layer Y is a hole injection layer and the layer X is an electron transport layer);
f) anode/hole injection layer/light-emitting layer/electron transport layer/electron injection layer/cathode (the configuration in FIG. 12 in which the layer X is a hole injection layer and the structure in FIG. 16 is adopted as the layer Y);
d) anode/hole transport layer/light-emitting layer/cathode (the configuration in FIG. 13 in which the layer Y is a hole transport layer);
e) anode/hole transport layer/light-emitting layer/electron injection layer/cathode (the configuration in FIG. 12 in which the layer Y is a hole transport layer and the layer Y is an electron injection layer);
f) anode/hole transport layer/light-emitting layer/electron transport layer/cathode (the configuration in FIG. 12 in which the layer Y is a hole transport layer and the layer X is an electron transport layer);
g) anode/hole transport layer/light-emitting layer/electron transport layer/electron injection layer/cathode (the configuration in FIG. 12 in which the layer Y is a hole transport layer, and the layer X has the structure of electron transport layer X2/electron injection layer X1 shown in FIG. 15);
h) anode/hole injection layer/hole transport layer/light-emitting layer/cathode (the configuration in FIG. 13 in which the layer Y has the structure of hole injection layer Y1/hole transport layer Y2 shown in FIG. 16);
i) anode/hole injection layer/hole transport layer/light-emitting layer/electron injection layer/cathode (the configuration in FIG. 12 in which the layer Y has the structure of hole injection layer Y1/hole transport layer Y2 shown in FIG. 16, and the layer X is an electron injection layer);
j) anode/hole injection layer/hole transport layer/light-emitting layer/electron transport layer/cathode (the configuration in FIG. 12 in which the layer Y has the structure of hole injection layer Y1/hole transport layer Y2 shown in FIG. 16, and the layer X is an electron transport layer);
k) anode/hole injection layer/hole transport layer/light-emitting layer/electron transport layer/electron injection layer/cathode (the configuration FIG. 12 in which the layer Y has the structure of hole injection layer Y1/hole transport layer Y2 shown in FIG. 16, and the layer X has the structure of electron transport layer X2/electron injection layer X1 shown in FIG. 15);
l) anode/light-emitting layer/electron injection layer/cathode (the configuration in FIG. 14 in which the layer X is an electron injection layer);
m) anode/light-emitting layer/electron transport layer/cathode (the configuration in FIG. 14 in which the layer X is an electron transport layer); and
n) anode/light-emitting layer/electron transport layer/electron injection layer/cathode (the configuration in FIG. 14 in which the layer X has the structure of electron transport layer X2/electron injection layer X1 shown in FIG. 15).

It is noted that the symbol "/" indicates that the layers that sandwich the symbol "/" are stacked adjacent to each other. The same is applicable below.

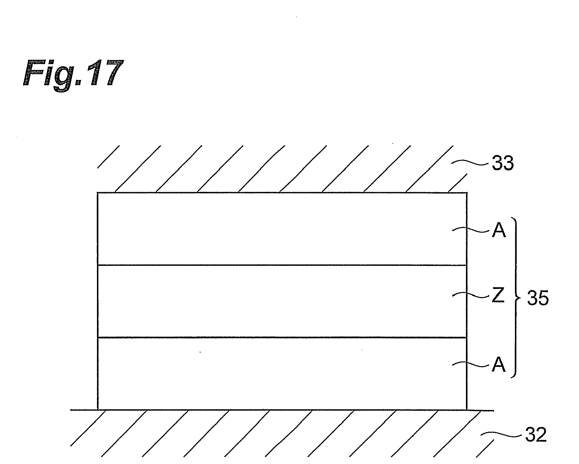

The organic EL element in the present embodiment may have two or more light-emitting layers. The organic EL element having two light-emitting layers may have a layered structure shown by o) below, as shown in FIG. 17, wherein a stack sandwiched between the anode and the cathode is assumed as a "repetition unit A" in one of the layered structures of a) to n) above.

o) anode/(repetition unit A)/charge injection layer Z/(repetition unit A)/cathode

More specifically, in FIG. 17, a plurality of stacks A (repetition units A) are interposed between the electrodes 32 and 33, and a charge injection layer Z is interposed between the stacks A.

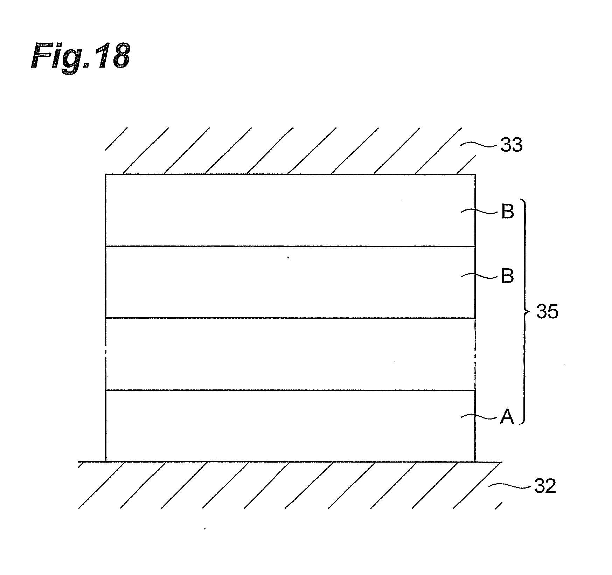

The organic EL element having three or more light-emitting layers may have a layered structure shown by p) below, as shown in FIG. 18, wherein "(repetition unit A)/charge injection layer Z" is assumed as a "repetition unit B."
p) anode/(repetition unit B)x/(repetition unit A)/cathode

It is noted that the symbol "x" represents an integer equal to or greater than two, and (repetition unit B)x represents a stack in which x repetition units B are stacked.

More specifically, in FIG. 18, the stacks B (repetition units B) as many as the number x are interposed between the electrodes 32 and 33. The stack A is located adjacent to the outermost one of a plurality of stacks B, and the electrode 32 is adjacent to the stack A.

Here, the charge injection layer (Z) is a layer that generates holes and electrons by applying an electric field. Examples of the charge injection layer include thin films made of vanadium oxide, indium tin oxide (abbreviated as ITO), and molybdenum oxide.

The organic EL element generally has the anode arranged on the substrate side. However, the cathode may be arranged on the substrate side. The order and number of stacked layers and the thickness of each layer can be set as appropriate considering light emission efficiency and element life.

The material of each layer that constitutes the organic EL element and a method of forming the same will now be described more specifically.

### <Support Substrate>

The support substrate suitably used is the one that does not change in the process of manufacturing an organic EL element. For example, any of glass, plastic, a high polymer film and a silicon substrates, and a laminate thereof may be used. A driving substrate in which a circuit driving the organic EL elements is formed may be used as the support substrate. For example, a TFT (Thin Film Transistor) substrate may be provided as the support substrate.

### <Anode>

In the case of an organic EL element configured such that light emitted from the light-emitting layer (34) passes through the anode (electrode 32) to be output to the outside of the element, an electrode exhibiting light transmittance is used for the anode. A thin film (hereinafter also referred to as a "conductive resin electrode") configured such that a wire-like conductor having conductivity is arranged in a film body exhibiting light transmittance can be used as the electrode.

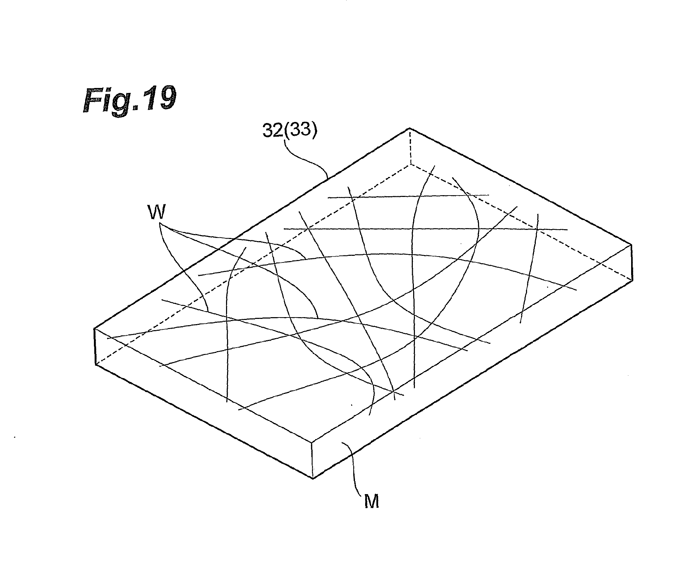

FIG. 19 is a perspective view of the lower electrode 32 (or the upper electrode 33) formed of a conductive resin electrode. Such a conductive resin electrode can be formed, for example, by a coating method. A film body M is configured to include a resin, an inorganic polymer, an inorganic-organic hybrid compound, and the like, and the one in which the transmittance of light in the visible light region is high is suitably used. A resin having conductivity is suitably used as the film body M. The electrical resistance can be decreased by using the film body M having conductivity in addition to a wire-like conductor W in this manner. The film thickness of the electrode is set as appropriate depending on the electrical resistance and the transmittance of visible light. The film thickness of the electrode is, for example, 0.02 µm to 2 µm, preferably 0.02 to 1 µm.

The smaller diameter of the wire-like conductor W is preferred. The diameter of the wire-like conductor is, for example, 400 nm or less, preferably 200 nm or less, and more preferably 100 nm or less. The wire-like conductor arranged in the film body diffracts or scatters light passing through the electrode and thus increases the Haze Factor and reduces the transmittance of light. However, the Haze Factor for visible light can be reduced and the reduction in the transmittance of light can be prevented by using the wire-like conductor W having a diameter equivalent to the wavelength of visible light or smaller than the wavelength of visible light. If the diameter of the wire-like conductor is too small, the resistance becomes high. Therefore, the diameter thereof is preferably 10 nm or more.

One or a plurality of wire-like conductors W may be arranged in the film body M and preferably form a mesh structure in the film body. For example, preferably, in the film body M, one or a plurality of wire-like conductors W are arranged so as to be complicatedly intertwined all over the film body to form a mesh structure. For example, a structure in which one wire-like conductor W is complicatedly intertwined or a plurality of wire-like conductors W are arranged in contact with each other may two-dimensionally or three-dimensionally extend to form a mesh structure. The volume resistivity of the conductive resin electrode (electrode 32) can be decreased by this wire-like conductor W forming a mesh structure.

The wire-like conductor W may be shaped, for example, like a curve or a needle. The curve-shaped and/or needle-shaped conductors are in contact with each other to form a mesh structure, resulting in an electrode having a low volume resistivity.

### (Wire-Like Conductor)

A metal having a low resistance is suitably used as the material of the wire-like conductor W. Examples of such metal include Ag, Au, Cu, Al, and alloys thereof. The wire-like conductor W can be manufactured, for example, by a method by N.R. Jana, L. Gearheart and C.J. Murphy (Chm. Commun., 2001, p617-p618) or a method by C. Ducamp-Sanguesa, R. Herrera-Urbina, and M. Figlarz, et al. (J. Solid State Chem., Vol. 100, 1992, p272-p280). Examples of the wire-like conductor W include a silver nanowire (the longer axis average length of 1 µm, the shorter axis average length of 10 nm) having a surface protected by the amino group-containing polymeric dispersant (manufactured by ICI Japan Ltd. under the product name "Solsperse 24000SC").

Examples of the method of forming a thin film configured such that the wire-like conductor W having conductivity is arranged in the film body M exhibiting light transmittance include a method of dispersing the wire-like conductor W in resin (film body M) by kneading the wire-like conductor W into resin, a method of forming a film of a dispersion liquid in which the wire-like conductor W and resin are dispersed into a dispersion medium using a prescribed coating method, and a method of coating a surface of a resin film with the wire-like conductor W and dispersing the conductor W into the film. A variety of additives such as surfactants and antioxidants may be added to the dispersion liquid as necessary. The kind of resin is selected as appropriate depending on the characteristics required for the electrode, such as refractive index, light transmittance, and electrical resistance.

The amount of the wire-like conductor W being dispersed affects the electrical resistance, Haze Factor, light transmittance, etc. of the electrode and therefore is set as appropriate depending on the characteristics required for the conductive resin electrode.

The conductive resin electrode can be obtained by applying a dispersion liquid in which the wire-like conductor W having conductivity is dispersed into a dispersion medium, by a prescribed coating method to form a film, and then hardening this film.

The dispersion liquid is prepared by dispersing the wire-like conductor W and resin into a dispersion medium. Any dispersion medium may be used as long as it dissolves or disperses resin, and examples thereof include chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, and ester-based solvents such as ethyl acetate, butyl acetate, and ethyl cellosolve acetate.

Examples of the resin include: polyolefin-based resins such as low-density or high-density polyethylene, ethylene-propylene copolymer, ethylene-butene copolymer, ethylene-hexene copolymer, ethylene-octene copolymer, ethylene-norbornene copolymer, ethylene-dimethano-octahydronaphthalene copolymer, polypropylene, ethylene-vinyl acetate copolymer, ethylene-methyl methacrylate copolymer, and ionomer resins; polyester-based resins such as polyethylene terephthalate, polybutylene terephthalate, and polyethylene naphthalate; nylon-6, nylon-6,6, metaxylenediamine-adipic acid polycondensate; amide-based resins such as polymethylmethacrylimide; acrylic-based resins such as polymethyl methacrylate; styrene-acrylonitrile-based resins such as polystyrene, styrene-acrylonitrile copolymer, styrene-acrylonitrile-butadiene copolymer, and polyacrylonitrile; hydrophobicized cellulose-based resins such as cellulose triacetate and cellulose diacetate; halogen-containing resins such as polyvinyl chloride, polyvinylidene chloride, polyvinylidene fluoride, and polytetrafluoroethylene; hydrogen-bonding resins such as polyvinyl alcohol, ethylene-vinyl alcohol copolymer, and cellulose derivative; and engineering plastic-based resins such as polycarbonate resins, polysulfone resins, polyether sulfone resins, polyether ether ketone resins, polyphenylene oxide resins, polymethylene oxide resins, polyarylate resins, and liquid crystalline resins.

A resin having conductivity is suitably used as this resin. Examples of the resin having conductivity include polyaniline and polythiophene derivatives. For example, a solution of poly(ethylene dioxythiophene)/polystyrene sulfonic acid having a refractive index of 1.7 (manufactured by H.C. Starck Ltd. under the product name "BaytronP") can be used.

The refractive index of the conductive resin electrode is mainly determined by the refractive index of the film body composed of resin and the like. The conductive resin electrode exhibiting the intended refractive index can be easily formed by selecting the resin to be used, since the refractive index of the film body is mainly determined, for example, by the kind of resin to be used. For example, when one electrode is provided in contact with the support substrate, the difference in refractive index between one electrode and the support substrate is preferably smaller. For example, the absolute value of the difference is preferably less than 0.4, and 1.8 or less is preferable as the numerical value of the refractive index. The refractive index of the conductive resin electrode can be set to the expected value by appropriately selecting the kind of resin to be used for the film body, so that the relation of the refractive index with the support substrate can be set within the range above.

By using a dispersion liquid in which the wire-like conductor is dispersed in a photosensitive material for use in photosensitive photoresist and light-curable monomer, the electrode having a prescribed pattern shape can be easily formed by a coating method and photolithography. For example, trimethylol propane triacrylate (manufactured by Shin-Nakamura Chemical Co., Ltd. under the product name "NK ester-TMPT") and a polymerization initiator (manufactured by Nihon Ciba-Geigy K.K. under the product name "IRGACURE 907") can be used.

Examples of the coating method using the dispersion liquid in which the wire-like conductor is dispersed include a dipping method, a coating method using a bar coater, a coating method using a spin coater, a doctor blade method, a spray coating method, a screen mesh printing method, brushing, spraying, and roll coating. In the case where thermosetting resin or light-curable resin is used, after the dispersion liquid is applied, the coat can be hardened by heating or light radiation.

ITO is generally used for the electrode exhibiting light transmittance. The refractive index of ITO is about 2, the refractive index of the glass substrate is about 1.5, and the refractive index of the portion in contact with ITO (for example, the light-emitting layer) is about 1.7. Therefore, when ITO is used as the electrode, the structure is such that ITO having a higher refractive index is sandwiched between the glass substrate and the light-emitting layer having a lower refractive index. Therefore, part of light emitted from the light-emitting layer is reflected by ITO, for example, through total reflection, so that light cannot be efficiently output to the outside in some cases. However, reflection at the electrode can be prevented by using the conductive resin electrode having a low refractive index as described above, so that light can be efficiently output to the outside.

Other than the conductive resin electrode described above, any of thin films of metal oxides, metal sulfides, and metals, having high electrical conductivity, can be used as the anode. Specifically, any of thin films of indium oxide, zinc oxide, tin oxide, ITO, indium zinc oxide (abbreviated as IZO), gold, platinum, silver, and copper may be used. Among these, a thin film of ITO, IZO, or tin oxide is suitably used. Examples of the method of fabricating the anode may include vacuum deposition, sputtering, ion plating, and plating methods. An organic transparent conductive film such as the film made of polyaniline or derivatives thereof or polythiophene or derivatives thereof may be used as the anode.

A material that reflects light may be used for the anode. Metal, metal oxide, or metal sulfide, having a work function of 3.0 eV or more, is preferable as the material.

The film thickness of the anode can be selected as appropriate in consideration of the transmittance of light and electric conductivity. The film thickness of the anode is, for example, 10 nm to 10 µm, preferably 20 nm to 1 µm, and more preferably 50 nm to 500 nm.

### <Hole Injection Layer>

Examples of the hole injection material that forms the hole injection layer include oxides such as vanadium oxide, molybdenum oxide, ruthenium oxide, and aluminum oxide, phenylamine-based compounds, starburst type amine-based compounds, phthalocyanine-based compounds, amorphous carbon, polyaniline, and polythiophene derivatives.

Examples of the method of forming the hole injection layer include film formation using a solution containing the hole injection material. The solvent used for the film formation using a solution is not particularly limited as long as the solvent dissolves the hole injection material. Examples of the solvent may include chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, ester-based solvents such as ethyl acetate, butyl acetate, and ethyl cellosolve acetate, and water.

Examples of the method of film formation using a solution may include coating methods such as nozzle printing, spin coating, casting, micro-gravure coating, gravure coating, bar coating, roll coating, wire bar coating, dip coating, spray coating, screen printing, flexographic printing, offset printing, and ink-jet printing methods. In the present embodiment, the nozzle printing method described above is suitably used.

The film thickness of the hole injection layer is appropriately set to the optimal value based on the element design. The film thickness of the hole injection layer is, for example, 1 nm to 1 µm, preferably 2 nm to 500 nm, and more preferably 5 nm to 200 nm.

### <Hole Transport Layer>

Examples of the hole transport material that forms the hole transport layer include polyvinylcarbazole or derivatives thereof, polysilane or derivatives thereof, polysiloxane derivatives having an aromatic amine in their side chain or main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylene vinylene) or derivatives thereof, or poly(2,5-thienylene vinylene) or derivatives thereof.

Among these, preferred as the hole transport material are polymer hole transport materials such as polyvinylcarbazole or derivatives thereof, polysilane or derivatives thereof, polysiloxane derivatives having an aromatic amine compound group in their side chain or main chain, polyaniline or derivatives thereof, polythiophene or derivatives thereof, polyarylamine or derivatives thereof, poly(p-phenylene vinylene) or derivatives thereof, or poly(2,5-thienylene vinylene) or derivatives thereof. More preferred are polyvinylcarbazole or derivatives thereof, polysilane or derivatives thereof, or polysiloxane derivatives having an aromatic amine in their side chain or main chain. When a low molecular weight hole transport material is used, it is preferable to disperse the transport material in a polymer binder.

The method of forming the hole transport layer is not limited. Examples of the method using a low molecular weight hole transport material may include film formation using a mixed liquid containing a polymer binder and the hole transport material. Examples of the method using a polymer hole transport material may include film formation using a solution containing the hole transport material.

The solvent to be used for film formation using a solution is not limited as long as it can dissolve the hole transport material. Examples of the solvent may include chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, and ester-based solvents such as ethyl acetate, butyl acetate, and ethyl cellosolve acetate.

As the method of film formation using a solution, a coating method similar to the method of forming the hole injection layer described above may be used. In the present embodiment, the nozzle printing method described above is suitably used.

As the polymer binder to be mixed, a binder which does not excessively inhibit charge transport is preferred, and a binder in which absorption of visible light is weak is suitably used. Examples of such binders may include polycarbonate, polyacrylate, polymethylacrylate, polymethylmethacrylate, polystyrene, polyvinylchloride, and polysiloxane.

The film thickness of the hole transport layer is set to the optimal value depending on the element design. The film thickness of the hole transport layer is, for example, 1 nm to 1 µm, preferably 2 nm to 500 nm, and more preferably 5 nm to 200 nm.

### <Light-Emitting Layer>

The light-emitting layer is generally formed of an organic material that mainly emits fluorescence and/or phosphorescence or of the organic material and an assist dopant therefor. The dopant is added for the purpose of improving the light-emission efficiency and changing the wavelength of emitted light. The organic material may be either a low molecular compound or a high molecular compound. The light-emitting layer preferably includes a high molecular compound having a number-average molecular weight of 10³ to 10⁸ in terms of polystyrene. Examples of the light-emitting material that forms the light-emitting layer include the following dye-based materials, metal complex-based materials, polymer-based materials, and dopant materials.

### (Dye-Based Material)

Examples of the dye-based material may include cyclopendamine derivatives, tetraphenyl butadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimer, pyrazoline dimer, quinacridone derivatives, and coumarin derivatives.

### (Metal Complex-Based Material)

Examples of the metal complex-based material may include metal complexes having central metals such as Al, Zn, Be or rare earth metals such as Tb, Eu and Dy and ligands such as oxadiazole, thiadiazole, phenylpyridine, phenylbenzimidazole, and a quinoline structure. Specific examples of the metal complex-based material may include metal complexes, such as iridium complexes and platinum complexes, that emit light from a triplet excited state, an aluminum quinolinol complex, a benzoquinolinol beryllium complex, a benzoxazolyl zinc complex, a benzothiazole zinc complex, an azomethyl zinc complex, a porphyrin zinc complex, and an europium complex.

### (Polymer-Based Material)

Examples of the polymer-based material may include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized products of the above dye-based materials or metal complex-based light-emitting materials.

Among the above light-emitting materials, examples of materials that emit blue light may include distyrylarylene derivatives, oxadiazole derivatives, and polymers thereof, polyvinylcarbazole derivatives, polyparaphenylene derivatives, polyfluorene derivatives, and the like. Among these, polymer materials such as polyvinylcarbazole derivatives, polyparaphenylene derivatives, and polyfluorene derivatives are preferred.

Examples of materials that emit green light may include quinacridone derivatives, coumarin derivatives, and polymers thereof, polyparaphenylene vinylene derivatives, polyfluorene derivatives, and the like. Among these, polymer materials such as polyparaphenylene vinylene derivatives and polyfluorene derivatives are preferred.

Examples of materials that emit red light may include coumarin derivatives, thiophene ring compounds, and polymers thereof, polyparaphenylene vinylene derivatives, polythiophene derivatives, and polyfluorene derivatives. Among these, polymer materials such as polyparaphenylene vinylene derivatives, polythiophene derivatives, and polyfluorene derivatives are preferred.

### (Dopant Material)

Examples of the dopant material may include perylene derivatives, coumarin derivatives, rubrene derivatives, quinacridone derivatives, squalium derivatives, porphyrin derivatives, styryl-based dyes, tetracene derivatives, pyrazolone derivatives, decacyclene, and phenoxazone. The thickness of such a light-emitting layer is generally about 2 nm to about 200 nm.

### <Method of Forming Light-Emitting Layer>

A method of applying a solution containing the light-emitting material, a vacuum vapor deposition method, a transferring method, or the like may be used as the method of forming the light-emitting layer. Examples of the solvent used for film formation using a solution include a solvent similar to the solvent used when the hole transport layer is formed using the aforementioned solution.

Examples of the method of applying a solution containing the light-emitting material may include coating methods such as spin coating, casting, micro-gravure coating, gravure coating, bar coating, roll coating, wire bar coating, dip coating, slit coating, capillary coating, spray coating, and nozzle printing methods, and printing methods such as gravure printing, screen sprinting, flexographic printing, offset printing, reverse printing, and ink-jet printing methods. In the present embodiment, the nozzle printing method as described above is suitably used.

### <Electron Transport Layer>

As an electron transport material that forms the electron transport layer, the well-known one may be used. Examples of such a material may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or 8-hydroxyquinoline or metal complexes of derivatives thereof, polyquinoline or derivatives thereof, polyquinoxaline or derivatives thereof, and polyfluorene or derivatives thereof.

Among these, preferred as the electron transport material are oxadiazole derivatives, benzoquinone or derivatives thereof, anthraquinone or derivatives thereof, or 8-hydroxyquinoline or metal complexes of derivatives thereof, polyquinoline or derivatives thereof, polyquinoxaline or derivatives thereof, and polyfluorene or derivatives thereof. More preferred are 2-(4-biphenylyl)-5-(4-t-butylphenyl)-1,3,4-oxadiazol, benzoquinone, anthraquinone, tris(8-quinolinol)aluminum, and polyquinoline.

The method of forming the electron transport layer is not particularly limited. Examples of the method using a low molecular weight electron transport material may include a vacuum vapor deposition method using powder and film formation from a solution or molten state. Examples of the method using a polymer electron transport material may include the film formation from a solution or molten state. When the film formation from a solution or molten state is used, a polymer binder may also be used. Examples of the method of forming the electron transport layer using a solution may include a film formation method similar to the method of forming the hole transport layer using a solution as described above. In the present embodiment, the nozzle printing method described above is suitably used.

The film thickness of the electron transport layer has the optimal value varying depending on the material used and is set as appropriate such that the driving voltage and the light-emission efficiency have appropriate values. At least such a thickness that prevents the formation of pinholes is required. Too large a thickness is undesirable since the driving voltage of the element becomes high. Therefore, the film thickness of the electron transport layer is, for example, 1 nm to 1 µm, preferably 2 nm to 500 nm, and more preferably 5 nm to 200 nm.

### <Electron Injection Layer>

As the material that forms the electron injection layer, the optimal material is selected as appropriate depending on the type of the light-emitting layer. Examples of such a material may include alkali metals, alkaline earth metals, alloys containing at least one of alkali metals and alkaline earth metals, oxides, halides, and carbonates of alkali metals or alkaline earth metals, or mixtures of these materials. Examples of such alkali metals and the oxides, halides, and carbonates of the alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of such alkaline earth metals and the oxides, fluorides, and carbonates of the alkaline earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be a stack of two or more layers, and may be LiF/Ca, for example. The electron injection layer is formed by, for example, a vapor deposition method, a sputtering method, or a printing method. The film thickness of the electron injection layer is preferably about 1 nm to 1µm.

### <Cathode>

As the materials of the cathode, the material in which the work function is small, the electron injection into the light-emitting layer is easy, and the electric conductivity is high is preferred. For the organic EL element in which light is taken out from the anode side, a material with a high reflectivity for visible light is preferred as the material for the cathode in order to reflect light from the light-emitting layer to the anode side from the cathode. For the cathode, for example, alkali metals, alkaline earth metals, transition metals, and metals in Group 13 may be used. Examples of the material used for the cathode may include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, alloys of two or more of the above metals, alloys of one or more of the above metals and one or more of gold, silver, platinum, copper, manganese, titanium, cobalt, nickel, tungsten, and tin, or graphite or graphite intercalated compounds. Examples of the alloy may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

A conductive resin electrode that can be formed by the coating method as described in the section of the anode, or a transparent conductive electrode made of a conductive metal oxide or a conductive organic material may be used as the cathode (electrode 33). Specific examples of the conductive metal oxide may include indium oxide, zinc oxide, tin oxide, ITO, and IZO. Examples of the conductive organic material may include polyaniline or derivatives thereof and polythiophene or derivatives thereof. The cathode may be a stack of two or more layers. The electron injection layer is used as the cathode in some cases.

The electrode 33 that forms a cathode may include the film body M and the conductor W which is formed of a plurality of nanowires dispersed in the film body M, as shown in FIG. 19. The electrode internal structure of the cathode in this case is the same as the case of the anode.

The film thickness of the cathode is set as appropriate in consideration of electric conductivity and durability. The film thickness of the cathode is, for example, 10 nm to 10 µm, preferably 20 nm to 1 µm, and more preferably 50 nm to 500 nm.

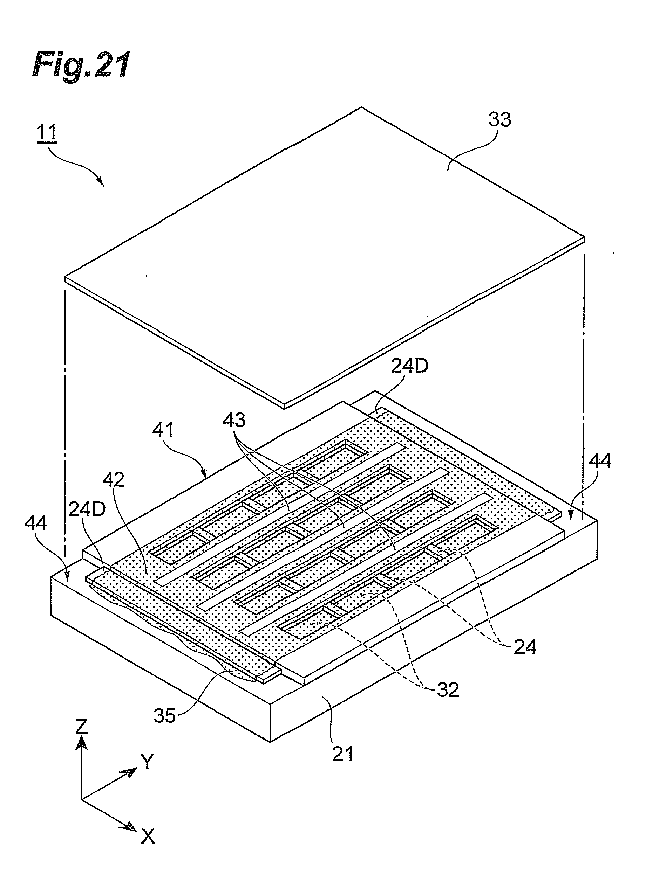

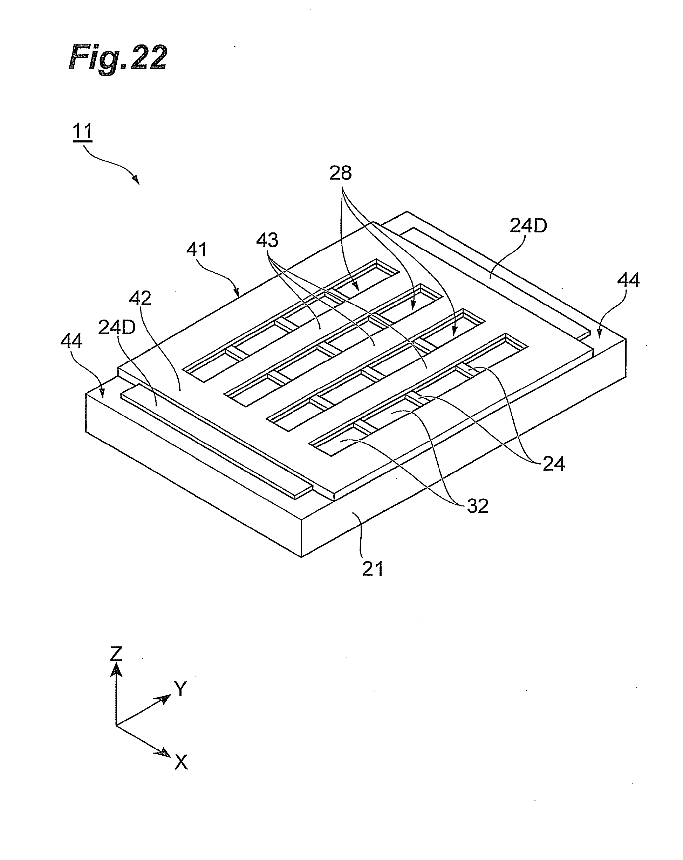

In the embodiment described above, the dummy electrode is provided. However, in another embodiment, as shown in FIG. 21 and FIG. 22, a dummy insulating film 24D formed of the same member as the insulating film 24 may be provided in place of the dummy electrode 45.

FIG. 21 is a perspective view of the light-emitting device 11 using the dummy insulating film. FIG. 22 is a perspective view of the light-emitting device 11 before formation of the light-emitting layer using the dummy insulating film. To be more specific, the dummy insulating film 24D is provided on the bottom surface of the depression 44 (the surface of the support substrate 21) and is provided such that the depression 44 reaches the surface of the dummy insulating film 24D. In this embodiment, the bottom portion of the depression 44 corresponds to the surface of the dummy insulating film 24D. The light-emitting device in FIG. 21 and FIG. 22 differs from the foregoing embodiment only in that the dummy insulating film 24D is used in place of the dummy electrode 45, and the other configuration is the same as that of the light-emitting device shown in FIG. 8 and FIG. 9. In this embodiment, the dummy insulating film 24D having the same shape (rectangle) as the dummy electrode 45 is instead provided at the position of the dummy electrode 45. The dummy insulating film 24D may be produced in the same process step as the insulating film 24, and these insulating films 24D and 24 may be continuous.

The dummy insulating film may be provided at a place where the dummy electrode in the foregoing embodiment is provided. The dummy insulating film may be formed integrally with the insulating film. More specifically, the insulating film may be extended to the place where the dummy electrode in the foregoing embodiment is formed, and the insulating film extended to the place where the dummy electrode is provided may serve as the dummy insulating film.

Preferably, the dummy insulating film is formed in the same process step as the step of forming the insulating film. In this manner, the dummy insulating film can be formed in the same process step as the insulating film by forming the dummy insulating film as the same member as the insulating film. Therefore, the dummy insulating film can be formed without increasing the number of process steps.

In the case where the dummy insulating film is provided in place of the dummy electrode, the insulating film and the dummy insulating film preferably exhibit a greater affinity for liquid than the partition wall. Specifically, the bottom portion of the depression is preferably formed of a material whose contact angle with respect to anisole is less than 30°. The dummy insulating film serving as the bottom portion of the depression is preferably formed of a material whose contact angle with respect to anisole is less than 30°. Therefore, it is necessary to form the insulating film using such a material that the insulating film exhibits an affinity for liquid, among those illustrated as the materials of the insulating film. Examples of the material of the insulating film and the dummy insulating film include oxides such as SiO₂, oxynitrides, and SiN. Oxides such as SiO₂ and oxynitrides are preferred, and SiO₂ having a high affinity for liquid is more preferred.

Examples of the method of fabricating the cathode may include a vacuum vapor deposition method, a sputtering method, and a laminating method of thermocompression-bonding a metal thin film.

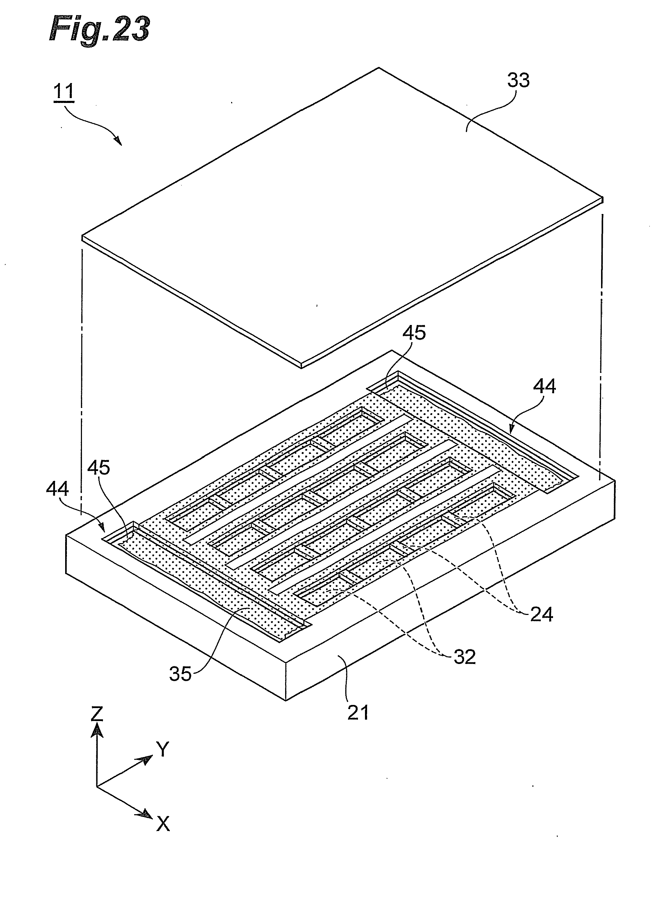

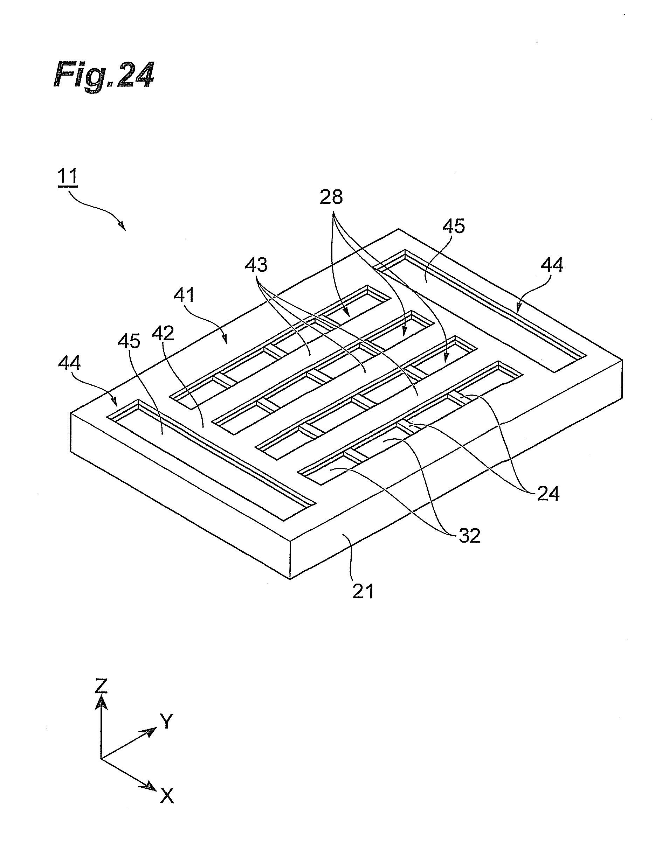

The depression 44 may be a depression having an opening surrounded by the partition wall material (resist), as shown in FIG. 23 and FIG. 24. FIG. 23 is a perspective view of the light-emitting device 11 using the depression portion having an opening. FIG. 24 is a perspective view of the light-emitting device 11 before formation of the light-emitting layer using the depression portion having an opening. The light-emitting device in FIG. 23 and FIG. 24 differs from the foregoing embodiment only in that the depression 44 is shaped such that the depression portion has a rectangular opening, and the other configuration is the same as that of the light-emitting device shown in FIG. 8 and FIG. 9.

The light-emitting device explained above can be suitably used for a display device and is applicable to, for example, a backlight of a liquid crystal display device, an illumination device, a light source of a scanner, and the like.

### Reference Signs List

- 1: substrate
- 2: partition wall
- 2a: peripheral portion
- 2b: divider portion
- 3: support substrate
- 4: one electrode
- 5: insulating film
- 11: light-emitting device
- 21: support substrate
- 24: insulating film
- 28: opening
- 31: organic EL element
- 32: one electrode
- 41: partition wall
- 42: peripheral portion
- 43: divider portion
- 44: depression
- 45: dummy electrode

## Claims

1. A light-emitting device comprising:
a support substrate;
a plurality of organic electroluminescence elements provided on the support substrate; and
a partition wall separating the plurality of organic electroluminescence elements from each other, wherein
the partition wall has a peripheral portion arranged so as to surround a region in which the plurality of organic electroluminescence elements are provided, and a plurality of divider portions arranged in a striped pattern in a region surrounded by the peripheral portion and each having one end and the other end in a longitudinal direction coupled to the peripheral portion,
the organic electroluminescence elements are arranged between the divider portions adjacent to each other, and
a depression extending toward the support substrate is provided in the peripheral portion on an extended line in the longitudinal direction of the divider portions.

2. The light-emitting device according to claim 1, wherein a bottom surface of the depression is made of a material whose contact angle with respect to anisole is less than 30°.

3. The light-emitting device according to claim 1, wherein each of the organic electroluminescence elements includes a pair of electrodes,
the light-emitting device further includes a dummy electrode on a bottom surface of the depression, the dummy electrode being formed of a same material as one electrode of the pair of electrodes that is arranged closer to the support substrate, and
the depression is provided so as to reach a surface of the dummy electrode.

4. The light-emitting device according to claim 3, wherein the one electrode and the dummy electrode are formed by a coating method.

5. The light-emitting device according to claim 3, wherein the one electrode is formed such that a wire-like conductor having conductivity is arranged in a film body exhibiting light transmittance.

6. The light-emitting device according to claim 1, further comprising: an insulating film electrically insulating the plurality of organic electroluminescence elements from each other; and a dummy insulating film formed of a same member as the insulating film, wherein
the insulating film is provided between the partition wall and the support substrate,
the dummy insulating film is provided on a bottom surface of the depression, and
the depression is provided so as to reach a surface of the dummy insulating film.
